# EUROPEAN PATENT APPLICATION

(11) **EP 4 642 210 A1**
(43) Date of publication of application: **29.10.2025**
(21) Application number: 25165330.9
(22) Date of filing: 21.03.2025
(51) Int. Cl.: H10K 85/50, H10K 71/12, H10K 71/15, H10K 30/50

(54) **METHOD FOR MANUFACTURING A PEROVSKITE SOLAR CELL**

(30) Priority: 23.04.2024 JP 2024069749
(71) Applicant: TOYOTA JIDOSHA KABUSHIKI KAISHA, Toyota-shi, Aichi-ken, 471-8571 (JP)
(72) Inventor: MATSUNOBU, Kohei, Toyota-shi, 471-8571 (JP); OKUMURA, Kenichi, Toyota-shi, 471-8571 (JP)
(74) Representative: J A Kemp LLP

(57) **Abstract**

The present disclosure provides a method for manufacturing a perovskite solar cell that can suppress occurrence of pinholes. The present disclosure relates to a method for manufacturing a solar cell including a photoelectric conversion layer containing a perovskite compound. The method comprises: applying a precursor solution containing the perovskite compound as a solute over an application surface; and applying a poor solvent having a lower solubility for the perovskite compound than that of a solvent of the precursor solution over the application surface with the precursor solution applied, wherein a gas concentration of a volatile organic compound in a vicinity of the application surface is less than 15000 ppm at a timing when an application of the poor solvent is started.

## Description

### BACKGROUND

### Technical Field

The present disclosure relates to a method for manufacturing a perovskite solar cell.

### Background Art

There has been known a perovskite solar cell, in which a main component of a photoelectric conversion layer is a perovskite compound, as a type of solar cell.

As a method for manufacturing the perovskite solar cell, for example, JP 2023-148126 A discloses a method in which a material film of a perovskite thin film is applied, and then a gaseous or mist-like poor solvent is sprayed onto the material film of the perovskite thin film to dry and crystallize the material film of the perovskite thin film.

### SUMMARY

However, in the conventional method for manufacturing a perovskite solar cell, pinholes sometimes occur in a photoelectric conversion layer. Therefore, the present disclosure provides a method for manufacturing a perovskite solar cell that can suppress occurrence of pinholes.

The present inventors have found that, in the manufacture of a perovskite solar cell, occurrence of pinholes in a photoelectric conversion layer is suppressed by controlling a gas concentration at a timing of application of a poor solvent, and have completed the present disclosure.

That is, the examples of aspects of the present disclosure is as follows.
(1) A method for manufacturing a solar cell including a photoelectric conversion layer containing a perovskite compound comprises: applying a precursor solution containing the perovskite compound as a solute over an application surface; and applying a poor solvent having a lower solubility for the perovskite compound than that of a solvent of the precursor solution over the application surface with the precursor solution applied, wherein a gas concentration of a volatile organic compound in a vicinity of the application surface is less than 15000 ppm at a timing when an application of the poor solvent is started.
(2) In the method for manufacturing a solar cell according to (1), the gas concentration of the volatile organic compound in the vicinity of the application surface is 1000 ppm or more at the timing when the application of the poor solvent is started.
(3) In the method for manufacturing a solar cell according to (1) or (2), the gas concentration of the volatile organic compound in the vicinity of the application surface is 4000 ppm or less at the timing when the application of the poor solvent is started.
(4) In the method for manufacturing a solar cell according to any of (1) to (3), the gas concentration of the volatile organic compound in the vicinity of the application surface is less than 15000 ppm during a period from applying the precursor solution to applying the poor solvent.
(5) In the method for manufacturing a solar cell according to any of (1) to (4), the gas concentration of the volatile organic compound in the vicinity of the application surface is 7000 ppm or less during the period from applying the precursor solution to applying the poor solvent.

The present disclosure can provide a method for manufacturing the perovskite solar cell that can suppress the occurrence of pinholes in the photoelectric conversion layer.

### BRIEF DESCRIPTION OF THE DRAWINGS

FIG. 1 is a schematic cross-sectional view illustrating an exemplary structure of a solar cell of the present disclosure;
FIG. 2 is a schematic diagram illustrating a perovskite crystalline structure;
FIG. 3 is a flowchart illustrating a film forming step of a photoelectric conversion layer 4;
FIG. 4 is a schematic cross-sectional view for describing Step S1;
FIG. 5 is a schematic cross-sectional view for describing Step S2;
FIG. 6 is a schematic cross-sectional view for describing Step S3;
FIG. 7 is a graph showing changes in a gas concentration over time when the gas concentration of a volatile organic compound is changed by exhausting gas;
FIG. 8 is a partially enlarged view of the graph of FIG. 7;
FIG. 9 is a graph showing changes in a gas concentration over time when the gas concentration of the volatile organic compound is changed by blowing air; and
FIG. 10 is a partially enlarged view of the graph of FIG. 9.

### DETAILED DESCRIPTION

The following describes embodiments of the present disclosure in detail.

The present disclosure relates to a method for manufacturing a solar cell including a photoelectric conversion layer containing a perovskite compound.

The method for manufacturing the solar cell according to the present disclosure comprises a step of applying a precursor solution containing the perovskite compound as a solute over an application surface (Step S1), and a step of applying a poor solvent over the application surface with the precursor solution applied (Step S2).

In the present disclosure, in Step S2, a gas concentration of a volatile organic compound in the vicinity of the application surface at a timing when the application of the poor solvent is started is controlled within a specific range, thereby suppressing occurrence of pinholes in the photoelectric conversion layer.

### <Configuration of Solar Cell>

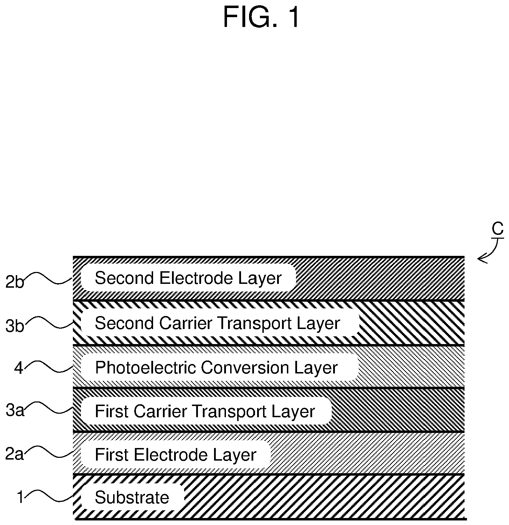

First, a structure of a perovskite solar cell (hereinafter, also referred to as a solar cell of the present disclosure) manufactured by the manufacturing method of the present disclosure will be described in detail. FIG. 1 is a schematic cross-sectional view illustrating an exemplary structure of the solar cell of the present disclosure.

As illustrated in FIG. 1, in one embodiment, a solar cell C of the present disclosure includes a substrate 1, a first electrode layer 2a, a first carrier transport layer 3a, a photoelectric conversion layer 4, a second carrier transport layer 3b, and a second electrode layer 2b.

### (Photoelectric Conversion Layer 4)

The photoelectric conversion layer 4 is a layer positioned between the first carrier transport layer 3a and the second carrier transport layer 3b. The photoelectric conversion layer 4 generates a charge carrier by receiving light.

The charge carrier generated in the photoelectric conversion layer 4 moves to any of the first carrier transport layer 3a or the second carrier transport layer 3b.

More specifically, the positive charge carriers, that is, the holes, generated in the photoelectric conversion layer 4 are transported to the first electrode layer 2a or the second electrode layer 2b via one of the first carrier transport layer 3a or the second carrier transport layer 3b corresponding to a hole transport layer.

The negative charge carriers, that is, the electrons, generated in the photoelectric conversion layer 4 are transported to the first electrode layer 2a or the second electrode layer 2b via one of the first carrier transport layer 3a or the second carrier transport layer 3b corresponding to an electron transport layer.

As will be described later, the manufacturing method of the present disclosure suppresses the occurrence of pinholes in the photoelectric conversion layer 4. In the solar cell of the present disclosure, the occurrence of pinholes in the photoelectric conversion layer is suppressed, and therefore a power generation performance is excellent and a short circuit is also avoided.

The photoelectric conversion layer 4 contains the perovskite compound, and may contain the perovskite compound as a main component. A content of the perovskite compound in the photoelectric conversion layer 4 is usually 60% by weight or more, 80% by weight or more in some embodiments, 90% by weight or more in some embodiments, 95% by weight or more in some embodiments, and 100% by weight in some embodiments.

A thickness of the photoelectric conversion layer is usually from 100 nm to 1000 nm.

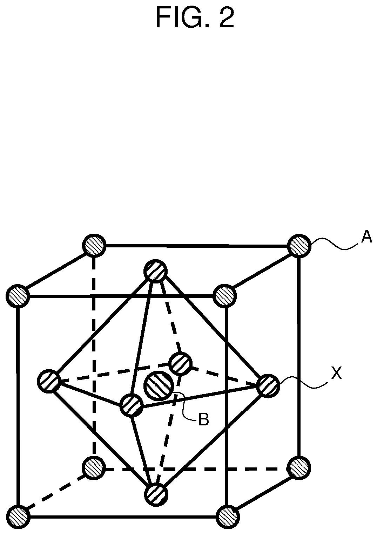

The perovskite compound is a compound having a perovskite crystalline structure. FIG. 2 is a schematic diagram illustrating the perovskite crystalline structure. As illustrated in FIG. 2, the perovskite crystalline structure has a unit cell of a cubic crystal system, where A is arranged at each vertex of the cubic crystal, B is arranged in the body center, and X is arranged at each face center of the cubic crystal having B at the center. The fact that the compound has a perovskite crystalline structure can be confirmed, for example, by an X-ray diffraction measurement.

For example, the perovskite compound can be represented by the following formula (1):

ABX₃ (1)

wherein A is a monovalent cation, B is a divalent cation, and X is a monovalent anion.

In one embodiment, in formula (1), A is at least one selected from a monovalent organic ammonium ion, a monovalent amidinium group ion, and a monovalent metal ion.

Examples of the monovalent organic ammonium ion include CH₃NH₃⁺ (methylammonium ion: MA), C₂H₅NH₃⁺, C₃H₇NH₃⁺, and C₄H₉NH₃ .

Examples of the monovalent amidinium group ion include HC(NH₂)₂⁺ (formamidinium ion: FA).

Examples of the monovalent metal ion include a rubidium ion (Rb⁺) and a cesium ion (Cs⁺).

In formula (1), A may be a combination of the monovalent organic ammonium ion, the monovalent amidinium group ion, and the monovalent metal ion. In some embodiments, in formula (1), A is MA, FA, or Cs⁺, and a combination of two or three thereof.

In one embodiment, in formula (1), B is a divalent metal ion, for example, a lead ion (Pb²⁺), a tin ion (Sn²⁺), and a combination thereof. From the aspect of durability, B is Pb²⁺ in some embodiments.

In one embodiment, in formula (1), X is a halogen ion, for example, at least one selected from a fluoride ion (F⁻), a chloride ion (Cl⁻), a bromide ion (Br⁻), and an iodide ion (I⁻), and X is Cl⁻, Br⁻, or I⁻ in some embodiments.

### (First Carrier Transport Layer 3a and Second Carrier Transport Layer 3b)

The description returns to FIG. 1.

The first carrier transport layer 3a receives the charge carrier generated in the photoelectric conversion layer 4 and transports the charge carrier to the first electrode layer 2a.

When the first carrier transport layer 3a is the hole transport layer (HTL), the first carrier transport layer 3a transports the holes to the first electrode layer 2a.

When the first carrier transport layer 3a is the electron transport layer (ETL), the first carrier transport layer 3a transports the electrons to the first electrode layer 2a.

The hole transport layer and the electron transport layer will be described in detail later.

The second carrier transport layer 3b receives the charge carrier generated in the photoelectric conversion layer 4 and transports the charge carrier to the second electrode layer 2b.

When the second carrier transport layer 3b is the hole transport layer, the second carrier transport layer 3b transports the holes to the second electrode layer 2b.

When the second carrier transport layer 3b is the electron transport layer, the second carrier transport layer 3b transports the electrons to the second electrode layer 2b.

In the first embodiment, the first carrier transport layer 3a is the electron transport layer, and the second carrier transport layer 3b is the hole transport layer. That is, in the first embodiment, the solar cell C of the present disclosure includes a substrate, a cathode, an electron transport layer, a photoelectric conversion layer, a hole transport layer, and an anode in order of mention.

In the second embodiment, the first carrier transport layer 3a is the hole transport layer, and the second carrier transport layer 3b is the electron transport layer. That is, in the second embodiment, the solar cell C of the present disclosure includes a substrate, an anode, a hole transport layer, a photoelectric conversion layer, an electron transport layer, and a cathode in order of mention.

The hole transport layer has a function of transporting the holes generated by photoelectric conversion in the photoelectric conversion layer to the first electrode layer or the second electrode layer. As a material of the hole transport layer, a known organic material or inorganic material that can be used for the hole transport layer can be used.

The organic material that can be used as the material of the hole transport layer is not particularly limited, and examples thereof include 2,2',7,7'-Tetrakis-(N,N-di-4-methoxyphenylamino)-9,9'-spirobifluorene (Spiro-OMeTAD), polyethylenedioxythiophene:polystyrene sulfonate (PEDOT:PSS), poly[bis(4-phenyl)(2,4,6-trimethylphenyl)amine] (PTAA), and 3PATAT-C3 (Non-patent Literature: Journal of the American Chemical Society, 2023, Vol. 145, Page 7528).

The inorganic material that can be used as the material of the hole transport layer is not particularly limited, and examples thereof include nickel oxide and copper oxide.

In the first embodiment of the solar cell of the present disclosure described above, the material of the hole transport layer may be Spiro-OMeTAD, PTAA, and nickel oxide.

In the second embodiment of the solar cell of the present disclosure described above, the material of the hole transport layer may be PEDOT:PSS, PTAA, and nickel oxide.

The electron transport layer has a function of transporting the electrons generated by photoelectric conversion in the photoelectric conversion layer to the first electrode layer or the second electrode layer. As a material of the electron transport layer, a known organic material or inorganic material that can be used for the electron transport layer can be used.

The organic material that can be used as the material of the electron transport layer is not particularly limited, and examples thereof include a fullerene compound, a phenanthroline derivative (for example, bathocuproine), and polyethylenimines. Examples of the fullerene compound include fullerene (for example, C60 fullerene, C70 fullerene) and a derivative obtained by adding a substituent to fullerene (for example, [6,6]-phenyl-C₆₁-butyric acid methyl ester (also referred to as PCBM or [60]PCBM), [6,6]-phenyl-C₇₁-butyric acid methyl ester (also referred to as PCBM or [70]PCBM)).

The inorganic material that can be used as the material of the electron transport layer includes titanium oxide, tin oxide, zinc oxide, and the like.

In the first embodiment of the solar cell of the present disclosure described above, the material of the electron transport layer may be fullerene, PCBM, bathocuproine, polyethyleneimines, titanium oxide, and tin oxide.

In the second embodiment of the solar cell of the present disclosure described above, the material of the electron transport layer may be fullerene, PCBM, bathocuproine, and polyethyleneimines.

### (First Electrode Layer 2a and Second Electrode Layer 2b)

The first electrode layer 2a is an electrode in contact with the first carrier transport layer 3a. The second electrode layer 2b is an electrode in contact with the second carrier transport layer 3b.

Materials that can be used for the first electrode layer and the second electrode layer include metallic materials such as aluminum (Al), silver (Ag), and gold (Au), transparent conductive films such as indium tin oxide (ITO), indium zinc oxide (IZO), aluminum-doped zinc oxide (AZO), and fluorine-doped tin oxide (FTO), and carbon nanotubes, which are known materials for solar cell electrodes.

The materials of the first electrode layer and the second electrode layer are ITO, IZO, and FTO in some embodiments.

### (Substrate 1)

The substrate 1 is a plate-shaped or film-shaped member, which supports the first electrode layer 2a, the first carrier transport layer 3a, the photoelectric conversion layer 4, the second carrier transport layer 3b, and the second electrode layer 2b.

The material of the substrate 1 is not particularly limited, and examples thereof include an inorganic material such as glass, an organic material such as polyethylene, polyethylene terephthalate, polyethylene naphthalate, polyimide, polyamide, polyamide imide, liquid crystal polymer, and cycloolefin polymer, and a metallic material such as stainless steel and silicon.

The substrate 1 may be transparent or opaque. When light enters through the surface of the substrate, a transparent substrate is used. As the transparent substrate, a substrate made of glass, polyethylene terephthalate, polyethylene naphthalate, polyimide, polyamide, polyamide imide, or cycloolefin polymer can be used. When light enters through a side opposite to the substrate, an opaque substrate can be used.

### <Method for Manufacturing Solar Cell>

Next, a method for manufacturing a solar cell, that is, a manufacturing method of the present disclosure will be described in more detail.

In the manufacturing method according to the embodiment, the first electrode layer, the first carrier transport layer, the photoelectric conversion layer, the second carrier transport layer, and the second electrode layer are formed on the substrate 1 in order of mention, thereby manufacturing a solar cell. The manufacturing method according to the embodiment has a feature in a film forming step of the photoelectric conversion layer 4, and the film forming step of the other portions can be performed using the same method as that of the conventional photoelectric conversion element.

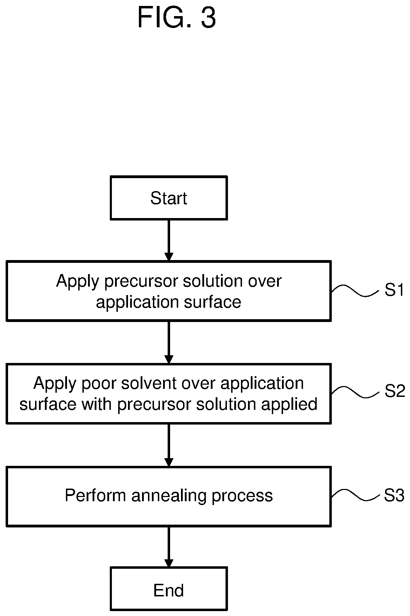

The following describes the film forming step of the photoelectric conversion layer 4 in detail. FIG. 3 is a flowchart illustrating the film forming step of the photoelectric conversion layer 4.

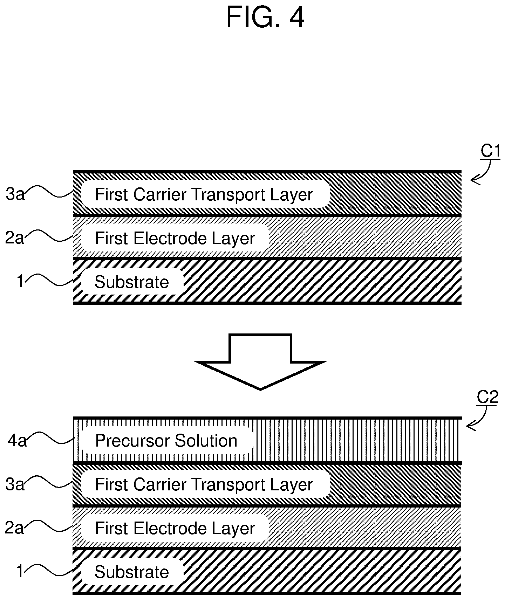

In the film forming step of the photoelectric conversion layer 4, first, a precursor solution is applied over an application surface (Step S1). FIG. 4 is a schematic cross-sectional view for describing Step S1.

More specifically, FIG. 4 is a schematic cross-sectional view illustrating cross-sectional surfaces of a photoelectric conversion element C1 before performing Step S1 and a photoelectric conversion element C2 being manufactured after performing Step S1.

As illustrated in FIG. 4, the photoelectric conversion element C1 before performing Step S1 includes the substrate 1, the first electrode layer 2a, and the first carrier transport layer 3a. As described above, the photoelectric conversion element C1 before performing Step S1 can be manufactured by forming the first electrode layer 2a and the first carrier transport layer 3a on the substrate 1 using a known method.

In Step S1 according to the embodiment, the precursor solution is applied over the surface of the first carrier transport layer 3a. That is, in the embodiment, the surface of the first carrier transport layer 3a corresponds to the application surface. The precursor solution applied over the surface of the first carrier transport layer 3a forms a liquid film 4a as illustrated in the schematic cross-sectional view of the photoelectric conversion element C2.

The precursor solution refers to a solution containing the perovskite compound as a solute. The precursor solution can be prepared by dissolving the perovskite compound, a solvent adduct of the perovskite compound, or a plurality of raw materials of the perovskite compound in an appropriate solvent.

For example, when the perovskite compound is represented by the above-described formula (1), the precursor solution can be prepared by dissolving one or more compounds represented by the following formula (2) and one or more compounds represented by the following formula (3) in an appropriate solvent.

AX (2)

BX₂ (3)

A solvent of the precursor solution is a polar solvent in some embodiments from the aspect of solubility for the perovskite compound. The solvent of the precursor solution is an aprotic solvent in some embodiments from the aspect of stability of the perovskite compound in the solution.

Examples of the solvent that can be used as the solvent of the precursor solution include N,N-dimethylformamide (DMF), dimethyl sulfoxide (DMSO), N-methylpyrrolidone (NMP), γ-butyrolactone, and a mixed solvent containing one or more thereof.

In Step S1 according to the embodiment, the surface of the first carrier transport layer 3a corresponds to the application surface. However, the application surface in Step S1 is not limited to the surface of the first carrier transport layer 3a.

For example, when the manufactured solar cell C does not include the first carrier transport layer, the precursor solution is applied over the first electrode layer 2a, and the surface of the first electrode layer 2a corresponds to the application surface.

When the manufactured solar cell C includes another layer between the photoelectric conversion layer 4 and the first carrier transport layer 3a, the precursor solution is applied over the other layer, and the surface of the other layer corresponds to the application surface.

That is, the application surface in Step S1 is appropriately selected according to the configuration of the manufactured solar cell C. More specifically, the application surface in Step S1 is a surface in contact with the photoelectric conversion layer 4 on the substrate side in the manufactured solar cell C.

The application of the precursor solution can be performed by a known method.

The method for applying the precursor solution may be any method as long as the precursor solution can be applied in the form of a substantially uniform layer on the application surface, and examples thereof include a spin coating method, an ink-jet method, a spray method, a blade coating method, and a die coating method.

Step S1 is performed under a dry air atmosphere in some embodiments, and is performed under an inert gas atmosphere in some embodiments, from the aspect of the stability of the perovskite compound. As the inert gas, any gas may be used as long as it does not react with the perovskite compound, and examples thereof include nitrogen and argon.

The description returns to FIG. 3. In the film forming step of the photoelectric conversion layer 4, after Step S1, a poor solvent is applied over the application surface with the precursor solution applied (Step S2).

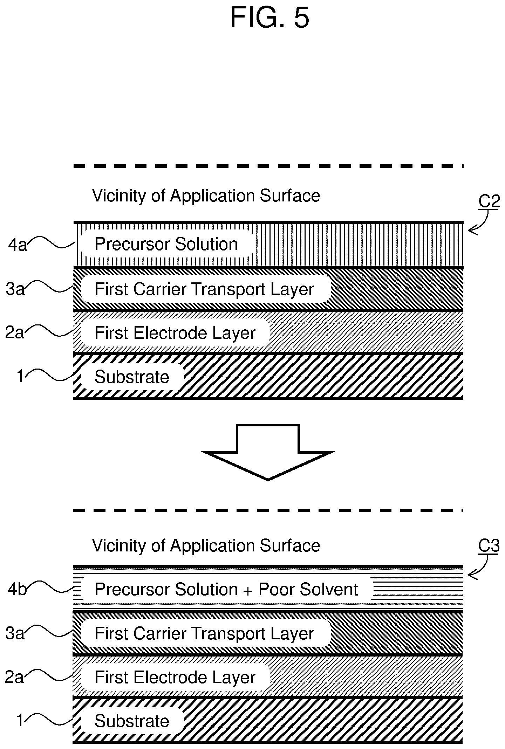

FIG. 5 is a schematic cross-sectional view for describing Step S2. More specifically, FIG. 5 is a schematic cross-sectional view illustrating cross-sectional surfaces of the photoelectric conversion element C2 before performing Step S2 and the photoelectric conversion element C3 being manufactured after performing Step S2.

As illustrated in FIG. 5, a liquid film 4b in which the precursor solution and the poor solvent are mixed is formed on the surface of the first carrier transport layer 3a by performing Step S2 according to the embodiment.

The formation of crystal nuclei of the perovskite compound is promoted in the mixed liquid film 4b by performing Step S2 according to the embodiment.

Here, the poor solvent is a solvent having a lower solubility for the perovskite compound than at least that of the solvent of the precursor solution, and is a solvent that cannot substantially dissolve the perovskite compound in some embodiments.

The poor solvent refers to, for example, a solvent having the solubility for the perovskite compound at 25°C (weight ratio of solute to 100 g of solvent) is usually less than 1% by weight, and less than 0.5% by weight in some embodiments.

The solvent that can be used as the poor solvent is not particularly limited, and examples thereof include an organic solvent such as a substituted aliphatic hydrocarbon such as dichloromethane and chloroform; an aromatic compound such as toluene, benzene, chlorobenzene, and tetralin; an ether such as diethyl ether and tetrahydrofuran (THF); an alcohol having 3 or more carbon atoms; a hydrocarbon having 4 to 10 carbon atoms; and acetic acid.

In the present disclosure, the aromatic compound includes a compound containing an aromatic ring in a part thereof. As the poor solvent, one of these solvents may be used alone or two or more thereof may be used in combination. In one embodiment, the poor solvent is chlorobenzene.

Step S2 according to the embodiment is performed with controlling the gas concentration of the volatile organic compound in the vicinity of the application surface within a specific range.

More specifically, in Step S2 according to the embodiment, the gas concentration of the volatile organic compound is controlled such that the gas concentration of the volatile organic compound in the vicinity of the application surface is less than 15000 ppm at the timing when the application of the poor solvent is started.

The vicinity of the application surface referred herein may be defined as a region where the gas concentration of the volatile organic compound measured in the region correlates with the volatilization rate of the solvent contained in the liquid film 4a or 4b located on the application surface. In one embodiment, the vicinity of the application surface refers to, for example, a region within 25 mm in a perpendicular direction from the application surface.

In Step S2, the gas concentration of the volatile organic compound at the timing of application of the poor solvent is controlled, thereby controlling the volatilization rate of the solvent in the liquid film 4b within an appropriate range. As a result, a sufficient number of crystal nuclei of the perovskite compound are uniformly formed in the liquid film 4b.

The formed crystal nuclei of the perovskite compound become the photoelectric conversion layer 4 by crystal growth through steps that will be described later. Therefore, in Step S2, by uniformly forming a sufficient number of crystal nuclei, the occurrence of pinholes is suppressed, and the photoelectric conversion layer 4 that uniformly contains the perovskite compound can be formed.

That is, in the method for manufacturing the solar cell according to the embodiment, the occurrence of pinholes in the photoelectric conversion layer 4 can be suppressed by configuring Step S2 as described above.

In the method for manufacturing the solar cell according to the embodiment, the photoelectric conversion layer 4 that uniformly contains the perovskite compound can be formed by configuring Step S2 as described above.

In Step S2 according to the embodiment, the gas concentration of the volatile organic compound in the vicinity of the application surface at the timing when the application of the poor solvent is started is less than 15000 ppm, and it is 10000 ppm or less in some embodiments, 7000 ppm or less in some embodiments, and 4000 ppm or less in some embodiments.

When the gas concentration of the volatile organic compound in the vicinity of the application surface is low, the occurrence of pinholes in the photoelectric conversion layer is further suppressed.

On the other hand, when the gas concentration of the volatile organic compound in the vicinity of the application surface at the timing when the application of the poor solvent is started is excessively reduced, a surface roughness of the photoelectric conversion layer increases.

Therefore, in Step S2, the gas concentration of the volatile organic compound in the vicinity of the application surface at the timing when the application of the poor solvent is started is 100 ppm or more in some embodiments, 1000 ppm or more in some embodiments, and 2000 ppm or more in some embodiments.

When the gas concentration of the volatile organic compound in the vicinity of the application surface is 1000 ppm or more, the surface roughness of the photoelectric conversion layer is sufficiently small.

When the surface roughness of the photoelectric conversion layer is sufficiently small, film thicknesses of layers adjacent to the photoelectric conversion layer can be sufficiently small, and therefore an increase in resistance of the solar cell can be suppressed.

From the above, in Step S2, the gas concentration of the volatile organic compound in the vicinity of the application surface at the timing when the application of the poor solvent is started is 1000 ppm or more and less than 15000 ppm in some embodiments, 1000 ppm or more and 10000 ppm or less in some embodiments, and 1000 ppm or more and 4000 ppm or less in some embodiments.

When the gas concentration of the volatile organic compound in the vicinity of the application surface is within this range, the occurrence of pinholes in the photoelectric conversion layer is suppressed, and the surface roughness of the photoelectric conversion layer is sufficiently small.

In the present disclosure, ppm used for the gas concentration represents ppm by volume.

In one embodiment, the timing when the application of the poor solvent is started may mean a timing immediately before the application of the poor solvent is started.

For example, the timing when the application of the poor solvent is started may mean a timing within one second before the start of the application of the poor solvent.

In another embodiment, when the poor solvent is dropped and applied as droplets, the timing when the application of the poor solvent is started may mean a timing when the dropping of the poor solvent is started.

In Step S2, for example, the gas concentration of the volatile organic compound in the vicinity of the application surface can be adjusted by exhausting gas or by blowing air.

In the case of the adjustment by exhausting gas, for example, the gas is removed from the vicinity of a workpiece using an exhaust mechanism such as an exhaust pipe, thereby allowing the gas concentration to be adjusted.

In the case of the adjustment by blowing air, an air blowing mechanism such as a circulator is used to blow air toward the workpiece, thereby allowing the gas concentration to be adjusted.

Step S2 is performed under a dry air atmosphere in some embodiments, and is performed under an inert gas atmosphere in some embodiments, from the aspect of the stability of the perovskite compound. As the inert gas, any gas may be used as long as it does not react with the perovskite compound, and examples thereof include nitrogen and argon.

In Step S2, the application of the poor solvent can be performed similarly to the application of the precursor solution in Step S1.

The description returns to FIG. 3. In the film forming step of the photoelectric conversion layer 4, after Step S2, an annealing process is performed, thereby completing the film formation of the photoelectric conversion layer 4 (Step S3).

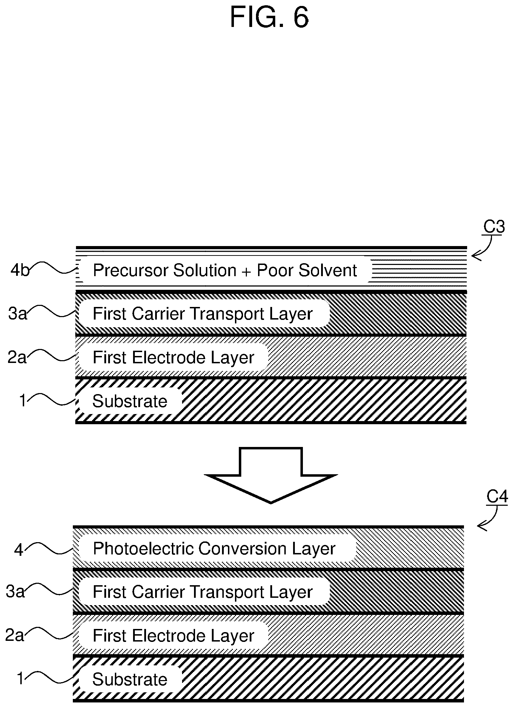

FIG. 6 is a schematic cross-sectional view for describing Step S3. More specifically, FIG. 6 is a schematic cross-sectional view illustrating cross-sectional surfaces of the photoelectric conversion element C3 before performing Step S3 and the photoelectric conversion element C4 being manufactured after performing Step S3.

As illustrated in FIG. 6, the photoelectric conversion layer 4 is formed on the surface of the first carrier transport layer 3a by performing Step S3 according to the embodiment.

The annealing process performed in Step S3 is usually a process of heating the liquid film 4b at a temperature of 70°C or higher and 200°C or lower.

The manufacturing method according to the present disclosure may include a drying step between Step S2 and Step S3. In the drying step, for example, the solvent in the liquid film is removed using a known drying method, such as a heating method, a method of blowing a drying gas, or a vacuuming method.

When no drying step is included between Step S2 and Step S3, Step S3 may be understood to be a process in which the annealing process and the drying process are performed in a one-step operation.

As described above, in the manufacturing method according to the embodiment, the gas concentration of the volatile organic compound in the vicinity of the application surface is less than 15000 ppm, and is 4000 ppm or less in some embodiments, at the timing when the application of the poor solvent is started.

With such a configuration, the manufacturing method according to the embodiment can suppress the occurrence of pinholes in the photoelectric conversion layer.

In the manufacturing method according to the embodiment, the gas concentration of the volatile organic compound in the vicinity of the application surface may be 1000 ppm or more at the timing when the application of the poor solvent is started.

With such a configuration, the manufacturing method according to the embodiment can reduce the surface roughness of the photoelectric conversion layer.

The gas concentration of the volatile organic compound in the vicinity of the application surface during a period from applying the precursor solution to applying the poor solvent may be less than 15000 ppm, and may be 7000 ppm or less in some embodiments.

With such a configuration, the manufacturing method according to the embodiment can further suppress the occurrence of pinholes in the photoelectric conversion layer.

### Examples

The following describes the present disclosure more specifically with reference to examples. However, the technical scope of the present disclosure is not limited to these examples.

A stacked body in which a glass plate, a fluorine-doped tin oxide (FTO) film (transparent conductive film), and a titanium oxide (TiO₂) layer (electron transport layer) were stacked in this order was used as a substrate. As a precursor solution, a solution was prepared by dissolving a ternary CsFAMAPbI₃ in a solvent including DMF and DMSO.

Under an argon gas atmosphere and at room temperature (25°C), the precursor solution was applied onto the electron transport layer of the substrate with different gas concentrations of the volatile organic compound during application. A poor solvent was added by drops to the applied precursor solution, and an annealing process was performed to form a perovskite film containing the perovskite compound on the substrate.

The gas concentration of the volatile organic compound during application was adjusted by exhausting gas and blowing air. The gas concentration of the volatile organic compound was measured by installing a PID-type gas concentration meter such that a distal end portion of a VOC (volatile organic compound) sensor was located at a position approximately 25 mm away from the application surface in a perpendicular direction.

### Gas Concentration Change by Exhausting Gas (Examples 1 to 6 and Comparative Examples 1 and 2)

An exhaust pipe was installed in a spin coater, and the opening degree of a valve installed in the exhaust pipe was set to three levels: large, medium, and small, to exhaust the gas in the spin coater. Experiments were performed twice for each exhaust condition.

The perovskite film was formed by the following procedure.
1. Start exhausting gas
2. Set a substrate on a spin coater stage
3. Drop a precursor solution onto the substrate
4. Start a rotation of the spin coater
5. Drop chlorobenzene (poor solvent) with a pipette during the rotation
6. Terminate the rotation of the spin coater
7. Remove the substrate and place it on a hot plate to perform an annealing process (120°C)

### Gas Concentration Change by Blowing Air (Examples 7 and 8)

A circulator was placed at a position approximately 15 cm away from a workpiece in a horizontal direction, and air was blown to the workpiece side with the circulator. The air volume of the circulator was set to two levels: large and small.

The perovskite film was formed by the following procedure.
1. Start blowing air
2. Set a substrate on a spin coater stage
3. Drop a precursor solution onto the substrate
4. Start a rotation of the spin coater
5. Drop chlorobenzene (poor solvent) with a pipette during the rotation
6. Terminate the rotation of the spin coater
7. Remove the substrate and place it on a hot plate to perform an annealing process (120°C)

The following analyses were performed on the perovskite film formed on the substrate.

### Pinhole Measurement

An image of the perovskite film was acquired with a transmission illumination type digital microscope. The acquired image was observed while applying light from a side opposite to the lens, and the visualized pinhole portion was subjected to an image analysis to measure the area (total area) and the number of the pinhole portions.

### Surface Roughness Sa

The surface of the perovskite film was observed with a white-light interference microscope, and a surface roughness Sa was calculated.

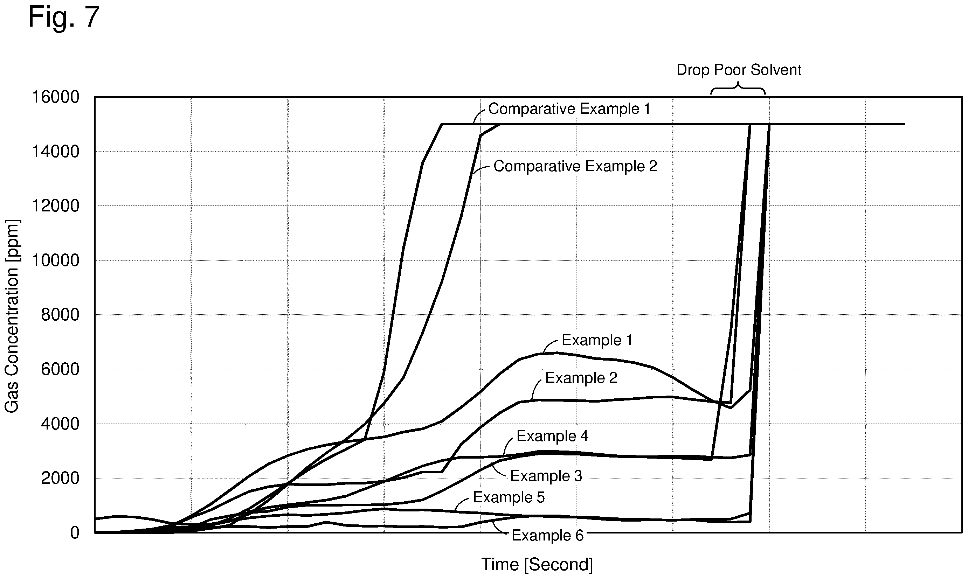

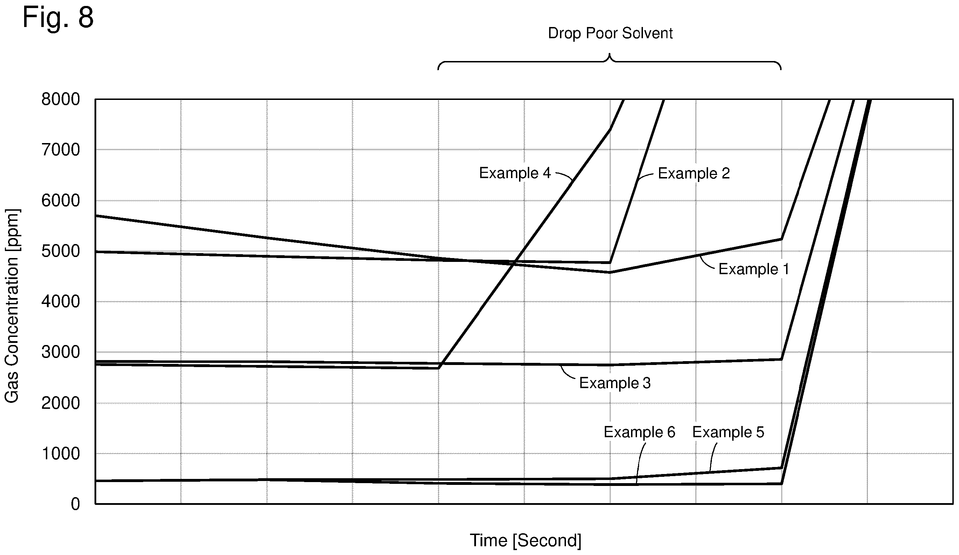

Table 1 shows analysis results of the perovskite film when the gas concentration of the volatile organic compound is changed by exhausting gas. FIG. 7 is a graph showing changes in the gas concentration over time when the gas concentration of the volatile organic compound is changed by exhausting gas. FIG. 8 is a partially enlarged view of the graph of FIG. 7.

**[Table 1]**

| | Gas Exhausting Condition | Pinhole | | |
|---|---|---|---|---|
| | | Area [µm²] | Count [Number] | Sa[nm] |
| Comparative Example 1 | None | 1184281 | 133 | - |
| Comparative Example 2 | None | 807940 | 80 | - |
| Example 1 | Small | 76785 | 18 | 8.165091 |
| Example 2 | Small | 42641 | 10 | 10.14171 |
| Example 3 | Medium | 1948 | 1 | 11.91161 |
| Example 4 | Medium | 0 | 0 | 9.630444 |
| Example 5 | Large | 0 | 0 | 26.90895 |
| Example 6 | Large | 0 | 0 | 31.00589 |

As shown in FIG. 7, when the gas was not exhausted (Comparative Examples 1 and 2), the gas concentration reached a measurement upper limit of the gas concentration meter (15000 ppm) before dropping the poor solvent. Therefore, in Comparative Examples 1 and 2, the gas concentrations before dropping the poor solvent were higher than 15000 ppm.

As shown in FIGS. 7 and 8, in Examples 1 to 6, the gas concentrations of the volatile organic compounds increased significantly after dropping the poor solvent. This shows that the gas concentration of the volatile organic compound before dropping the poor solvent corresponds to a concentration of a gas formed by volatilization of the solvent of the precursor solution, and the gas concentration of the volatile organic compound after dropping the poor solvent corresponds to a sum concentration of the gas formed by volatilization of the solvent of the precursor solution and a poor solvent gas formed by volatilization of the poor solvent.

As shown in Table 1, in Comparative Examples 1 and 2, a large number of pinholes occurred in the perovskite film. This is presumably because the high gas concentration in the environment caused a slow and uneven volatilization of the solvent in the liquid film, which led to a non-uniform formation of crystal nuclei in the plane, resulting in a state in which perovskite crystals were not formed in some parts.

As shown in FIGS. 7 and 8, when the amount of the gas exhausted was small and medium (Examples 1, 2, and Examples 3, 4, respectively), the generated solvent gas was exhausted, and therefore the gas concentration in the environment was reduced compared with the case where the gas was not exhausted. As shown in Table 1, in Examples 1 to 4, the formation of pinholes was suppressed by an appropriate volatilization of the solvent in the liquid film.

As shown in FIGS. 7 and 8, when the amount of the gas exhausted was large (Examples 5 and 6), the gas concentration in the environment was significantly reduced. As shown in Table 1, in Examples 5 and 6, the formation of pinholes was significantly suppressed and no pinholes were observed by the microscope observation, but on the other hand, the values of the surface roughness Sa were increased. It is presumed that the low gas concentration in the environment caused a rapid volatilization of the solvent in the liquid film, which led to an uneven crystal nuclei formation or crystal growth in the plane, causing the crystals to be partially raised and thus increasing the surface unevenness.

The above results show that, in the film formation of the perovskite film, the quality of the perovskite crystal is improved by maintaining an appropriate gas concentration of the volatile organic compound at the timing of application of the poor solvent.

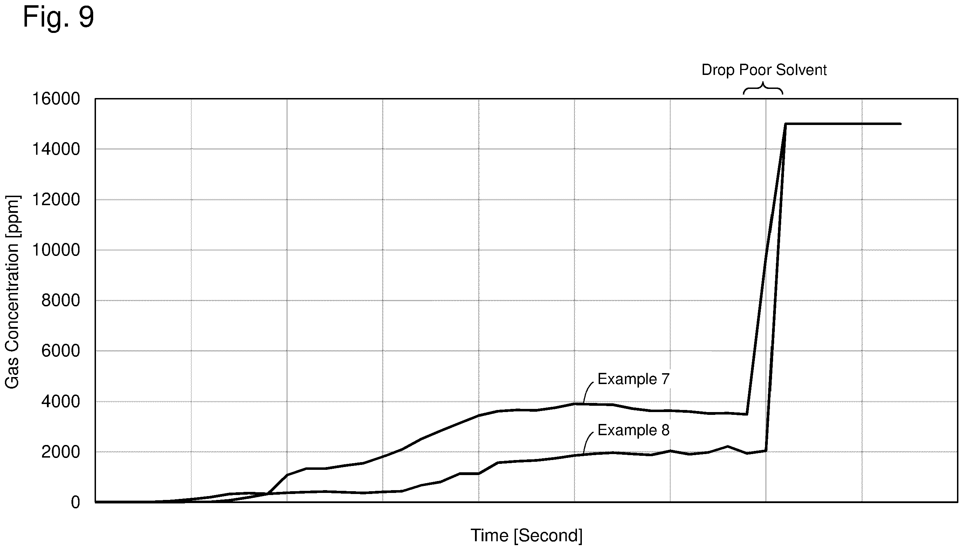

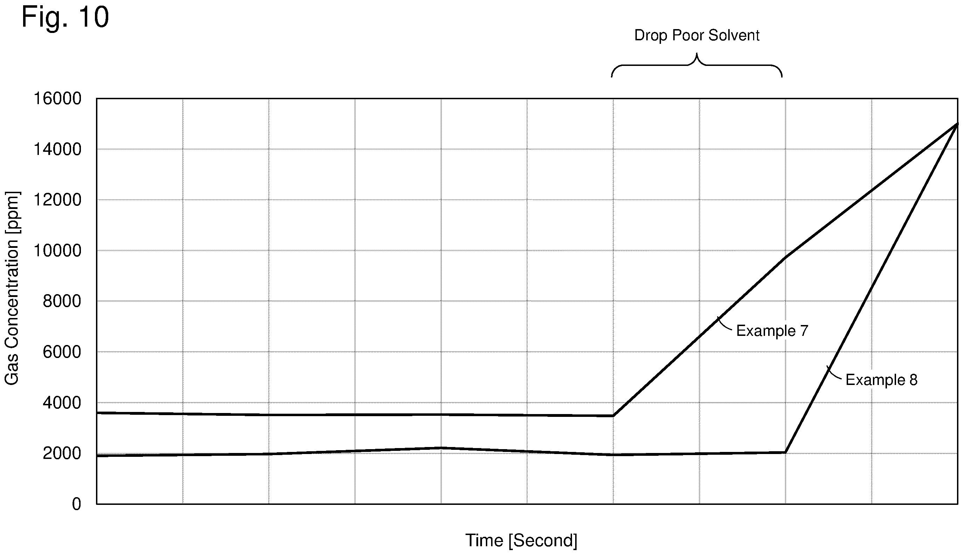

Table 2 shows analysis results of the perovskite film when the gas concentration of the volatile organic compound is changed by blowing air. FIG. 9 is a graph showing changes in the gas concentration over time when the gas concentration of the volatile organic compound is changed by blowing air. FIG. 10 is a partially enlarged view of the graph of FIG. 9.

**[Table 2]**

| | Air Blowing Condition | Pinhole | | |
|---|---|---|---|---|
| | | Area [µm²] | Count [Number] | Sa[nm] |
| Example 7 | Small | 0 | 0 | 12.93976 |
| Example 8 | Large | 0 | 0 | 14.55672 |

As shown in FIGS. 9 and 10 and Table 2, the formation of pinholes was suppressed, and further, the value of the surface roughness Sa was also sufficiently small by maintaining the appropriate gas concentration of the volatile organic compound at the timing of application of the poor solvent.

### DESCRIPTION OF SYMBOLS

- 1: Substrate
- 2a: First electrode layer
- 2b: Second electrode layer
- 3a: First carrier transport layer
- 3b: Second carrier transport layer
- 4: Photoelectric conversion layer
- 4a: Liquid film of precursor solution
- 4b: Liquid film in which precursor solution and poor solvent are mixed
- C: Solar cell
- C1, C2, C3, C4: Photoelectric conversion element

## Claims

1. A method for manufacturing a solar cell (C) including a photoelectric conversion layer (4) containing a perovskite compound, the method comprising:
applying a precursor solution containing the perovskite compound as a solute over an application surface; and
applying a poor solvent having a lower solubility for the perovskite compound than that of a solvent of the precursor solution over the application surface with the precursor solution applied, wherein a gas concentration of a volatile organic compound in a vicinity of the application surface is less than 15000 ppm at a timing when an application of the poor solvent is started.

2. The method for manufacturing a solar cell (C) according to claim 1,
wherein the gas concentration of the volatile organic compound in the vicinity of the application surface is 1000 ppm or more at the timing when the application of the poor solvent is started.

3. The method for manufacturing a solar cell (C) according to claim 1 or 2,
wherein the gas concentration of the volatile organic compound in the vicinity of the application surface is 4000 ppm or less at the timing when the application of the poor solvent is started.

4. The method for manufacturing a solar cell (C) according to any one of claims 1 to 3,
wherein the gas concentration of the volatile organic compound in the vicinity of the application surface is less than 15000 ppm during a period from applying the precursor solution to applying the poor solvent.

5. The method for manufacturing a solar cell (C) according to any one of claims 1 to 4,
wherein the gas concentration of the volatile organic compound in the vicinity of the application surface is 7000 ppm or less during the period from applying the precursor solution to applying the poor solvent.
